# EUROPÄISCHE PATENTSCHRIFT

(11) **EP 0 572 826 B1**
(45) Veröffentlichungstag und Bekanntmachung des Hinweises auf die Patenterteilung: **04.08.1999**
(21) Anmeldenummer: 93107690.5
(22) Anmeldetag: 11.05.1993
(51) Int. Cl.: H01L 29/74, H01L 29/10

(54) **Thyristor mit Durchbruchbereich**
Thyristor with break-down region
Thyristor avec région de claquage

(30) Priorität: 11.05.1992 DE 4215378
(43) Veröffentlichungstag der Anmeldung: 08.12.1993
(73) Patentinhaber: SIEMENS AKTIENGESELLSCHAFT, 80333 München (DE)
(72) Erfinder: Pfirsch, Frank, Dr.rer.nat., W-8000 München 90 (DE)

(56) Entgegenhaltungen:
- EP-A- 0 088 967
- EP-A- 0 129 702
- EP-A- 0 316 881
- DE-A- 3 225 991
- RESEARCH DISCLOSURE Nr. 302, Juni 1989, HAVANT GB Seite 449 'Method for achieving an overvoltage-protected thyristor' *
- PATENT ABSTRACTS OF JAPAN vol. 6, no. 238 (E-144)(1116) 26. November 1982& JP-A 57 138 175 ( HITACHI SEISAKUSHO K.K. ) 26. August 1982

## Beschreibung

In Hochspannungsanlagen sind im allgemeinen mehrere Thyristoren in Reihe geschaltet. Diese müssen stets gleichzeitig gezündet werden. Zündet einer der Thyristoren später, so liegt an ihm nahezu die gesamte Spannung an und der Thyristor wird zerstört. Man ist daher bemüht, Thyristoren zu entwickeln, die "über Kopf" gezündet werden können. Solche Thyristoren haben in aller Regel einen zentralen Bereich, der eine gegenüber dem übrigen Bereich und dem Rand niedrigere Durchbruchsspannung hat. Steigt die Spannung am Thyristor an, so geht dieser Bereich in den Avalanche-Durchbruch und der Durchbruchstrom kann den Thyristor direkt oder über einen oder mehrere Hilfsthyristorstrukturen zünden.

Ein solcher Thyristor ist beispielsweise aus der DE 32 25 991 C2 bekannt.

Das Dokument JP 57-138175 A (Patent Abstracts of Japan, Vol. 6, No. 238) beschreibt einen Thyristor, bei dem die Basiszone unter dem Emitter eine Aussparung aufweist. In der Aussparung befinden sich mehrere konvexe Bereiche, die mit der Basiszone verbunden sind und den gleichen Ladungstyp aufweisen. Die zusätzlichen Zonen sind in einem bestimmten Abstand zueinander und zu den Rändern der Aussparung angeordnet. Durch diese Anordnung kann der Gate-Zündstrom in seiner Stärke reduziert werden. Der Bereich unter der Aussparung weist eine gegenüber dem Basisbereich erhöhte Anzahl an Störstellen auf.

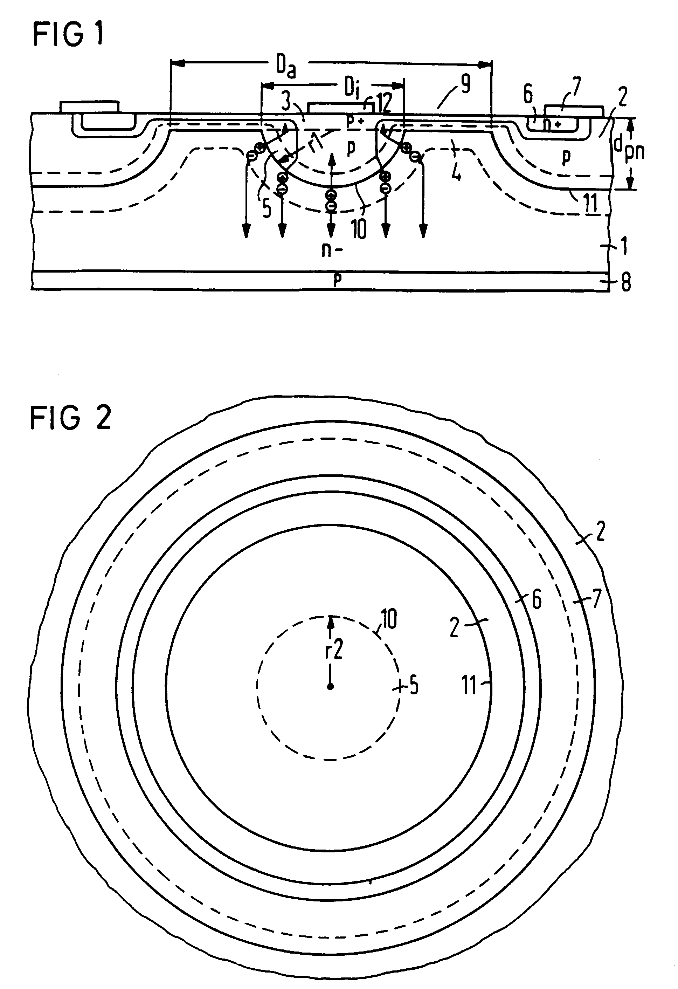

Der Durchbruchsbereich kann z. B. dadurch erzeugt werden, daß die katodenseitige Basiszone eine Aussparung hat, innerhalb der an der Oberfläche des Halbleiterkörpers eine dünnere Schicht des gleichen Leitfähigkeitstyp angeordnet ist. Der pn-Übergang zwischen der katodenseitigen Basiszone und der Innenzone hat dann beim Übergang von der Waggrechten in die Aussparung einen definierten Krümmungsradius, an dem eine gegenüber einem ebenen pn-Übergang höhere Feldstärke auftritt. An der Krümmung kommt es daher vorzugsweise zu einem Durchbruch des Thyristors. Eine Struktur dieser Art ist z. B. in dem Artikel "Design Consideration for High-Power, Overvoltage Self-Protected Thyristor" von Ohashi, Yoshida, Yamaguchi, Akagi, veröffentlicht in IPEC-Tokyo 183, Seiten 550 bis 558, insbesondere anhand von Figur 1B beschrieben worden.

Die Durchbruchseigenschaften des genannten Bereichs hängen von der Form des pn-Übergangs der katodenseitigen Basiszone ab. Außerdem überlagert sich die Feldstärkeerhöhung durch den beschriebenen definierten Krümmungsradius mit einer Feldstärkeverminderung, die durch die zylindrische Form der Aussparung und die dünne Oberflächenschicht bedingt ist. Der beschriebene Bereich verminderter Durchbruchsspannung ist daher nur bei großer Eindringtiefe der katodenseitigen Basiszone wirksam. Wird die dünne Oberflächenschicht weggelassen, erhöht sich zwar die Wirksamkeit des Bereiches. Die Durchbruchsspannung hängt dann aber stark von Oberlächenladungen und damit von der Prozeßführung ab, so daß sie nicht gut reproduzierbar ist.

Die Erfindung bezieht sich auf einen Thyristor mit einem Halbleiterkörper mit einer Innenzone vom ersten Leitungstyp und einer katodenseitigen Basiszone vom entgegengesetzten, zweiten Leitungstyp, mit einer Aussparung in der Basiszone, innerhalb der an der Oberfläche des Halbleiterkörpers eine gegenüber der Basiszone dünnere Schicht des zweiten Leitungstyps angeordnet ist, die mit der katodenseitigen Basiszone verbunden ist.

Ziel der vorliegenden Erfindung ist es, einen Thyristor der geschilderten Art derart weiterzubilden, daß der Bereich verminderter Durchbruchsspannung besser reproduzierbar und wirksamer ist.

Dieses Ziel wird dadurch erreicht, daß in der Aussparung eine zusätzliche Zone des zweiten Leitungstyps angeordnet ist, daß die Schicht mit der zusätzlichen Zone verbunden ist, daß die zusätzliche Zone dicker als die Schicht und im Abstand zur katodenseitigen Basiszone angeordnet ist und daß die zusätzliche Zone von der Innenzone gesehen mindestens teilweise konvex ist.

Weiterbildungen der Erfindung sind Gegenstand der Unteransprüche. Die Erfindung wird anhand eines Ausführungsbeispiels in Verbindung mit den Figuren 1 bis 3 näher erläutert. Es zeigen:
Figur 1 und 2 einen Schnitt durch und eine Aufsicht auf einen Thyristor gemäß hilfreich zum Verständnis der Erfindung und
Figur 3 ein Diagramm, das den Zusammenhang zwischen Durchbruchsspannung V BO und Durchmesser D i der zusätzlichen Zone mit dem Durchmesser D, der Aussparung als Parameter darstellt.

Der in Figur 1 und 2 dargestellte Thyristor hat eine schwach n-dotierte Innenzone 1. An diese schließt sich eine p-dotierte katodenseitige Basiszone 2 an. Die Basiszone 2 hat eine Aussparung 4. In der Aussparung 4 sitzt eine Schicht 3, die den gleichen Leitungstyp wie die Easiszone 2 hat. Sie reicht bis an die katodenseitige Oberfläche. Vorzugsweise ist die Schicht 3 höher dotiert als die Zone 2. In der Aussparung 4 ist außerdem eine zusätzliche Zone 5 angeordnet, die den gleichen Leitungstyp wie die katodenseitige Basiszone 2 hat. Sie ist mit der Schicht 3 verbunden und hat allseitig einen Abstand vom Rand der Aussparung 4, d. h. von der Basiszone 2.

In der Basiszone 2 ist eine Emitterzone 6 eingebettet, die beispielsweise die Hilfsemitterzone eines Hilfsthyristors sein kann. Sie ist durch eine Hilfsemitterelektrode 7 kontaktiert. Außerdem kontaktiert die Hilfseiritterelektrode 7 an der Außenseite auch die Basiszone 2.

Die Aussparung 4, die Schicht 3, die zusätzliche Zone 5, die Hilfsemitterzone 6 und die Elektrode 7 können, wie in Figur 2 dargestellt, kreisförmig bzw. ringförmig ausgebildet und konzentrisch zueinander angeordnet sein. Der pn-Übergang 10 zwischen zusätzlicher Zone 5 und Innenzone 1 hat dann in der Ebene der Oberfläche des Thyristors einen Radius r2 (Figur 2). Die zusätzliche Zone 5 kann in der Ebene senkrecht zur Oberfläche des Thyristors (Figur 1) die Form einer Kugelkalotte mit dem Radius r1 haben.

Die dargestellte Form der zusätzlichen Zone 5 ist jedoch nicht zwingend. Sie kann auch die Form einer üblichen Diffusionswanne haben und in der Aufsicht z. B. die Form eines Polygons. Wesentlich ist jedoch, daß die zusätzliche Zone 5 von der Innenzone 1 gesehen mindestens teilweise konvex ist. Zweckmäßigerweise wird die Zone 5 gleichzeitig mit der katodenseitigen Basiszone 2 z. B. durch Implantieren einer dünnen Schicht und nachfolgendes Eintreiben hergestellt. Die Schicht 3 wird z. 6. ebenfalls durch Implantieren und Eintreiben erzeugt.

Die Form der Aussparung 4 und der Zone 6 sind erfindungsgemäß polygonal geformt.

Die Elektrode 7 kann auch polygonal geformt sein.

Für einen Thyristor von etwa 8 kV wurde eine Grunddotierung der Innenzone 1 von etwa 1 x10¹³/cm³ eingestellt. Die katodenseitige Basiszone 2 kann eine Randdotierung größer 10¹⁶/cm³ haben. Die Zone 3 wird z. B. mit einer Dosis größer 10¹²/cm² und anschließendes Eintreiben auf z.B. eine Dicke von 5 µm hergestellt. Die Tiefe dₚₙ der pnÜbergänge 10, 11 der zusätzlichen Zone 5 bzw. der Basiszone 2 sind größer 40 µm.

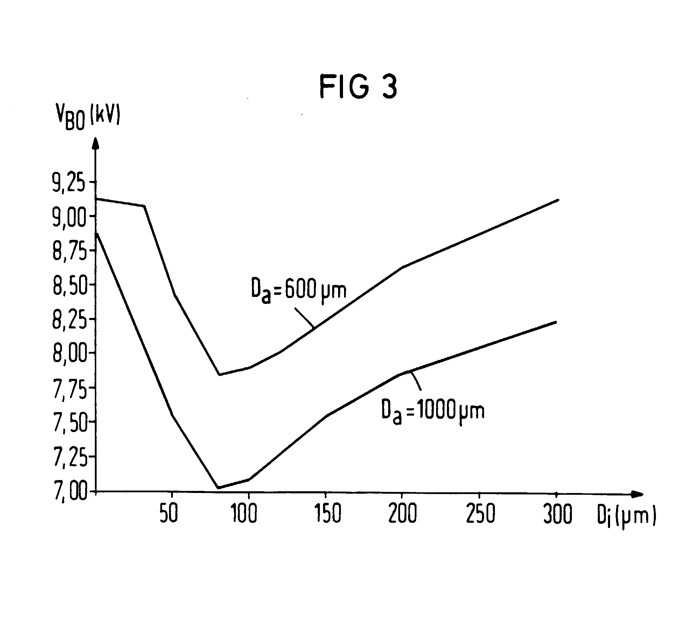

In Figur 3 ist der Zusammenhang zwischen Durchbruchsspannung V_{BO} und dem Durchmesser Dᵢ der zusätzlichen Zone 5 dargestellt. Es ist ersichtlich, daß für verschiedene Durchmesser Dₐ der Aussparung 4 die Durchbruchs spannung bei etwa einem Durchmesser Dᵢ von etwa 80 µm ein Minimum hat. Eine Absenkung ergibt sich allgemein schon dann, wenn der Durchmesser Dᵢ kleiner als der halbe Durchmesser Dₐ ist.

Die untere Grenze von Dᵢ liegt bei etwa 1/10 bis 1/20 des Durchmessers Dₐ, da bei weiterer Abnahme des Durchmessers Dᵢ die Durchbruchsspannung wieder ansteigt. Als zweckmäßig hat es sich außerdem erwiesen, wenn der Durchmesser Dᵢ der zusätzlichen Zone größer ist als die halbe Tiefe (dₚₙ) des pnÜbergangs der zusätzlichen Zone.

In Figur 1 ist dargestellt, daß sich bei Anlegen einer Spannung in Vorwärtsrichtung bevorzugt im Bereich der zusätzlichen Zone 5 Ladungsträgerpaare bilden, von denen sich die Elektronen zur anodenseitigen Emitterzone 8 und die Löcher zur Schicht 3 und dann unter der Hilfsemitterzone 6 zur Hilfsemitterelektrode 7 bewegen. Dieser Strom erhöht sich lawinenartig und leitet auf bekannte Weise die Zündung des Hilfsthyristors und damit des ganzen Thyristors ein.

Die Schicht 3 hat den Zweck, die katodenseitige Oberfläche des Thyristors vor Oberflächenladungen zu schätzen. Zu diesem Zweck ist sie, wie bereits erwähnt, hoher dotiert als die zusätzliche Zone 5 und die Basiszone 2.

Der Thyristor kann lichtsteuerbar sein. Sein lichtempfindlicher Bereich 9 umfaßt die Schicht 3 und die Zone 5, ggf. auch einen an die Schicht 3 angrenzenden Bereich der Basiszone 2. Die Erfindung läßt sich jedoch auch bei stromgesteuerten Thyristoren anwenden. hier ist dann die Schicht 3 oder die Basiszone einer der eingangs erwähnten Hilfsthyristoren von einer Steuerelektrode kontaktiert.

## Patentansprüche

1. Thyristor mit einem Halbleiterkörper mit einer Innenzone vom ersten Leitungstyp und einer katodenseitigen Basiszone (2) vom entgegengesetzten, zweiten Leitungstyp, mit einer Aussparung (4) in der Basiszone, innerhalb der Aussparung an der katodenseitigen Oberfläche des Halbleiterkörpers eine gegenüber der Basiszone (2) dünnere Schicht (3) des zweiten Leitungstyps angeordnet ist, die mit der katodenseitigen Basiszone (2) verbunden ist, wobei in der Basiszone im Abstand zu der Aussparung eine Emitterzone eingebettet ist,
**dadurch gekennzeichnet,** daß in der Aussparung (4) eine zusätzliche Zone (5) des zweiten Leitungstyps angeordnet ist, daß die Schicht (3) mit der zusätzlichen Zone (5) verbunden ist, daß die zusätzliche Zone (5) dicker als die Schicht (3) und im Abstand zur katodenseitigen Basiszone (2) angeordnet ist, daß die zusätzliche Zone (5) von der Innenzone gesehen mindestens teilweise konvex ist, daß die zusätzliche Zone und die Aussparung (4) in der Ebene der Oberfläche in der Form eines regelmäßigen Polygons ausgebildet sind, daß die zusätzliche Zone konzentrisch in der Aussparung sitzt, daß der Durchmesser (Dᵢ) der zusätzlichen Zone kleiner als der halbe Durchmesser (Dₐ) der Aussparung ist.

2. Thyristor nach Anspruch 1
**dadurch gekennzeichnet,** daß die zusätzliche Zone (5) die gleiche Tiefe (dₚₙ) wie die katodenseitige Basiszone (2) hat.

3. Thyristor nach einem der Ansprüche 1 oder 2
**dadurch gekennzeichnet,** daß die zusätzliche Zone (5) einen Durchmesser (Dᵢ) hat, der größer als die halbe Tiefe (dₚₙ) des pn-Übergangs (10) der zusätzlichen Zone (5) hat.

4. Thyristor nach einem der Ansprüche 1 bis 3,
**dadurch gekennzeichnet,** daß er durch Licht steuerbar ist und daß die zusätzliche Zone (5) und die Schicht (3) im lichtempfindlichen Bereich (9) des Thyristors liegen.

5. Thyristor nach Anspruch 4,
**dadurch gekennzeichnet,** daß der lichtempfindliche Bereich (9) von einer Hilfsemitterzone (6) umgeben ist.

6. Thyristor nach einem der Ansprüche 1 bis 3,
**dadurch gekennzeichnet,** daß die Schicht (3) von einer Gateelektrode kontaktiert ist.

7. Thyristor nach einem der Ansprüche 1 bis 6,
**dadurch gekennzeichnet,** daß die Schicht (3) eine höhere Dotierung als die zusätzliche Zone (5) und die Basiszone (2) hat.

## Claims

1. Thyristor with a semiconductor body having an inner zone of the first conduction type and a cathode-side base zone (2) of the opposite, second conduction type, having a recess (4) in the base zone, within which recess a layer (3) which is thinner than the base zone (2) and is of the second conduction type is arranged on the cathode-side surface of the semiconductor body, and is connected to the cathode-side base zone (2), an emitter zone being embedded in the base zone at a distance from the recess, characterized in that an additional zone (5) of the second conduction type is arranged in the recess (4), in that the layer (3) is connected to the additional zone (5), in that the additional zone (5) is thicker than the layer (3) and arranged at a distance from the cathode-side base zone (2), in that the additional zone (5) is at least partially convex as seen from he inner zone, in that the additional zone and the recess (4) are formed in the shape of a regular polygon in the plane of the surface, in that the additional zone lies concentrically in the recess, and in that the diameter (Dᵢ) of the additional zone is less than half the diameter (Dₐ) of the recess.

2. Thyristor according to Claim 1, characterized in that the additional zone (5) has the same depth (dₚₙ) as the cathode-side base zone (2).

3. Thyristor according to Claim 1 or 2, characterized in that the additional zone (5) has a diameter (Dᵢ) which is greater than half the depth (dₚₙ) of the pn junction (10) of the additional zone (5).

4. Thyristor according to one of Claims 1 to 3, characterized in that it is photocontrollable and in that the additional zone (5) and the layer (3) lie in the photosensitive region (9) of the thyristor.

5. Thyristor according to Claim 4, characterized in that the photosensitive region (9) is surrounded by an auxiliary emitter zone (6).

6. Thyristor according to one of Claims 1 to 3, characterized in that the layer (3) is in contact with a gate electrode.

7. Thyristor according to one of Claims 1 to 6, characterized in that the layer (3) has a higher doping level than the additional zone (5) and the base zone (2).

## Revendications

1. Thyristor comprenant un corps semi-conducteur présentant une zone interne du premier type de conduction et une zone de base (2) du second type de conduction, opposé, située du côté de la cathode, un évidement (4) dans la zone de base, à l'intérieur duquel est située, au niveau de la surface du corps semi-conducteur située du côté de la cathode, une couche (3) du second type de conduction plus mince que la zone de base (2) et qui est reliée à la zone de base (2) située du côté de la cathode, une zone d'émetteur étant insérée dans la zone de base à une distance de l'évidement, caractérisé en ce qu'une zone supplémentaire (5) du second type de conduction est située dans l'évidement (4), en ce que la couche (3) est reliée à la zone supplémentaire (5), en ce que la zone supplémentaire (5) est plus épaisse que la couche (3) et est située à une distance de la zone de base (2) située du côté de la cathode, en ce que la zone supplémentaire (5), vue de la zone interne, est au moins partiellement convexe, en ce que la zone supplémentaire et l'évidement (4) ont, dans le plan de la surface, la forme d'un polygone régulier, en ce que la zone supplémentaire est située de manière concentrique dans l'évidement, en ce que le diamètre (Dᵢ) de la zone supplémentaire est inférieur à la moitié du diamètre (Dₐ) de l'évidement.

2. Thyristor selon la revendication 1, caractérisé en ce que la zone supplémentaire (5) a la même profondeur (dₚₙ) que la zone de base (2) située du côté de la cathode.

3. Thyristor selon l'une des revendications 1 ou 2, caractérisé en ce que la zone supplémentaire (5) a un diamètre (Dᵢ) qui est supérieur à la moitié de la profondeur (dₚₙ) de la jonction pn (10) de la zone supplémentaire (5).

4. Thyristor selon l'une des revendications 1 à 3, caractérisé en ce qu'il est à commande optique et en ce que la zone supplémentaire (5) et la couche (3) sont situées dans la zone photosensible (9) du thyristor.

5. Thyristor selon la revendication 4, caractérisé en ce que la zone photosensible (9) est entourée par une zone d'émetteur auxiliaire (6).

6. Thyristor selon l'une des revendications 1 à 3, caractérisé en ce que la couche (3) est contactée par une électrode de grille.

7. Thyristor selon l'une des revendications 1 à 6, caractérisé en ce que la couche (3) a un dopage plus élevé que la zone supplémentaire (5) et la zone de base (2).
